# EUROPEAN PATENT SPECIFICATION

(11) **EP 0 414 226 B1**
(45) Date of publication and mention of the grant of the patent: **19.04.1995**
(21) Application number: 90116095.2
(22) Date of filing: 22.08.1990
(51) Int. Cl.: H01L 29/772, H01L 27/092

(54) **MOS field-effect transistor with sidewall spacers**
MOS-Feldeffekttransistor mit Seitenwand-Abstandsstücken
Transistor à effet de champ MOS avec parvoi latérale d'espacement

(30) Priority: 24.08.1989 JP 218960/89
(43) Date of publication of application: 27.02.1991
(73) Proprietor: NEC CORPORATION, Tokyo (JP)
(72) Inventor: Narita, Kaoru, Minato-ku, Tokyo (JP)
(74) Representative: Glawe, Delfs, Moll & Partner

(56) References cited:
- EP-A- 0 187 016
- EP-A- 0 198 335
- EP-A- 0 308 152
- IEEE TRANSACTIONS ON ELECTRON DEVICES, vol. ED-33, no. 11, November 1986, New York, US, pp. 1769-1179 ; Sergio BAMPI et al.: "A Modified Lightly Doped Drain Structure for VLSI MOSFET s"
- INTERNATIONAL ELECTRON DEVICES MEETING 1985, Washington DC, December 1-4, 1985, pp. 234-237 ; S. BAMPI et al. : "Modified LDD Device Structure for VLSI"
- PATENT ABSTRACTS OF JAPAN vol. 10, no. 16 (E-375)(2073) 22 January 1986 ; & JP-A-60 177 677

## Description

### BACKGROUND OF THE INVENTION

This invention relates to a MOS field-effect transistor with sidewall spacers at the gate electrode sides, and more particularly to such a type of field effect transistor formed in a lightly doped drain (LDD) structure (referred to as an LDD transistor hereinafter) according to the preamble of claims 1 and 2, and known from EP-A-0 308 152.

A LDD transistor in the prior art comprises source/drain layers of a lower impurity concentration (referred to as LIC hereinafter) on the surface of a semiconductor substrate underneath the sidewall spacers of insulating material and source/drain layers of a higher impurity concentration (referred to as HIC hereinafter) at respective sides of LIC source/drain layers. The surfaces of the HIC source/drain layers are at respective outer sides of the sidewall spacers and connected to source/drain electrodes, respectively. The reason why the LIC drain layer is located underneath the sidewall spacer is to prevent the undesirable effect of hot carriers. Without LIC drain layers, then electric field concentration would occur in the vicinity of the drain just beneath the gate electrode, thereby generating hot carriers which in turn would be injected into the gate-insulating layer, leading to varying threshold voltage of the transistor. The formation of the LIC drain layer causes the peak electric field to relocate underneath the sidewall spacer, resulting in suppressing the injection of hot carriers into the gate-insulating layer and in turn preventing the threshold voltage of the LDD transistor voltage from varying.

In a LDD transistor where the peak field effect is found underneath the sidewall spacer, hot carriers are injected into the sidewall spacer. This produces an undesirable phenomenon that degradation of the transistor noted as lowering the transconductance (gm) of the transistor with the lapse of time, occurs in the initial stage, not gradually but sharply. In an effort to prevent this, a slight increase in impurity concentration in the LIC drain layer can cause the peak electrid field to locate just underneath the gate electrode, but this results in inducing the above-mentioned varying threshold voltage.

The p-channel MOS transistor is less affected by hot carriers due to electric field concentration than is the n-channel MOS transistor. In conventional CMOS integrated circuits (referred to as ICs) therefore LDD structure was used only for the n-channel MOS transistor and not done for p-channel MOS transistors. Application of LDD structure to the p-channel MOS transistor as well, though advantageous from the viewpoint of improving the reliability, is difficult because the conventional CMOS ICs require additional photolithographic processing step for this.

Further prior art LDD-MOSFETs are disclosed in IEEE ED-33 (1986) No. 11, pages 1769-1779; International Electron Devices Meeting (1985), pages 234-237; and in EP-A-60 177 677. These devices comprise a region having the conductivity type of the substrate formed within the LDD.

### SUMMARY OF THE INVENTION

It therefore is an object of the invention to provide a LDD transistor structure capable of working with the undesirable effect of hot carriers minimized.

Another object of the invention is to provide a CMOS semiconductor IC structure permitting also a p-channel MOS transistor component to be easily or simply formed in the form of a LDD transistor structure.

A further object of the invention is to provide a CMOS semiconductor IC composed of a p-channel MOS transistor formed in a LDD structure and a n-channel MOS transistor formed in a LDD structure, thereby allowing minimized injection of hot carriers into the sidewall spacers.

The feature of the LDD transistor according to the invention resides in that on the surface of the LIC layer, except the edge portion thereof contiguous to the channel region, there is provided a layer of the opposite conductivity type impurity. More specifically, an impurity region of the opposite conductivity type to the LIC drain layer is formed on the surface of the semiconductor substrate just underneath the sidewall spacer, to be enclosed by the LIC drain layer which is angle-shaped so that the impurity region is on the horizontal part of the LIC drain layer and is separated by the vertical part thereof from the channel region. Also a high impurity level (HIC) layer is formed on the outer side (when viewing the channel region as center) of the sidewall spacer to flank with the opposite conductivity-type impurity region and the LIC drain layer.

The feature of the structure according to the invention results in the following: such opposite conductivity-type impurity is formed between the sidewall spacer and the LIC layer so that the LIC layer becomes buried deep, which in turn cause the peak electric field to be relocated deep, from the surface of the semiconductor substrate. As a result, injection of hot carriers into the sidewall spacer is suppressed, thus preventing degradation incident to the LDD.

The electric field concentration tends to be one-sided towards the drain layer. From this viewpoint, for the source layer neither LIC layer nor opposite conductivity-type impurity region is needed. Unless these are formed in the source layer, however, instead extra photolithographic processing steps would be required. It is rather preferred to form these also in the source layer than to add photolithographic processing steps. The present invention, though it can be applied both to n-channel MOS transistor and to p-channel MOS transistor, it coule be more effective if applied to n-channel MOS transistor. However, there is an advantage that the formation of p-channel MOS transistors in a LDD structure can be achieved without needing additional photolithographic processing steps.

In an alternative embodiment of the invention, a CMOS semiconductor IC is provided which consists of a n-channel MOS transistor formed in a p-conductivity type part of a semiconductor substrate and a p-channel MOS transistor formed in a n-conductivity type part of a semiconductor substrate.

The n-channel MOS transistor comprises a n-type source/drain layer formed apart from each other on the surface in the p-type part of the semiconductor substrate; a pair of n⁻-type source/drain layers formed on the surface in the p-type part of the semiconductor substrate and separated from each other by a channel region, each thereof at respective inner sides of the n-type source/drain layers and smaller in depth and lower in impurity concentration than the n-type source/drain layers; a pair of p⁻-type regions each formed to be on the pair of n⁻-type source/drain layers, respectively, and to be separated thereby from the channel region; a gate electrode formed above the channel region in the p-type part of the semiconductor substrate through the intermediation of a gate-insulating layer; a pair of sidewall spacers of insulating material each formed above the pair of p⁻-type regions, respectively, and flanked with sides of the gate electrode, respectively.

The p-channel MOS transistor comprises a p-type source and drain layer formed apart from each other on the surface in a n-type part of the semiconductor substrate; a pair of p⁻-type source/drain layers formed on the surface in the n-type part of the semiconductor substrate separated from each other by a channel region, each thereof at respective inner sides of the first p-type source/drain layers and being smaller in depth and lower in impurity concentration than the p-type source/drain layers; a gate electrode formed above the channel region in the n-type part of the semiconductor substrate through the intermediation of a gate-insulating layer; and a pair of sidewall spacers of insulating material each formed above the pair of p-type source/drain layers, respectively, and flanked by sides of the gate electrode, respectively.

A further alternative embodiment of the present invention provides a process of fabricating a n-channel MOS transistor suitable for use in CMOS ICs. This process comprises forming a gate electrode; introducing a first n-type impurity in self-alignment with the gate electrode into the surface in a p-type part of a semiconductor substrate; introducing a p-type impurity into the same surface as in the first n-type impurity introduction; forming a pair of sidewall spacers each at sides of the gate electrode, respectively; and introducing a second n-type impurity in self-alignment with the pair of sidewall spacers into a part of the same surface as in the first n-type impurity introduction.

### BRIEF DESCRIPTION OF THE DRAWINGS

The above-mentioned and other objects, features and advantages of the invention will become more apparent by reference to the following detailed description of the preferred embodiments, taken in conjunction with the accompanying drawings in which
Figs. 1A through 1G are longitudinal sectional views illustrative of the processing steps for fabricating a first embodiment of CMOS IC according to the present invention;
Fig. 1H is a plan view of the CMOS IC of Fig. 1G; and
Figs. 2A through 2C are longitudinal sectional views illustrative of the processing steps for fabricating a second embodiment of CMOS IC according to the present invention.

### DETAILED DESCRIPTION OF EMBODIMENTS

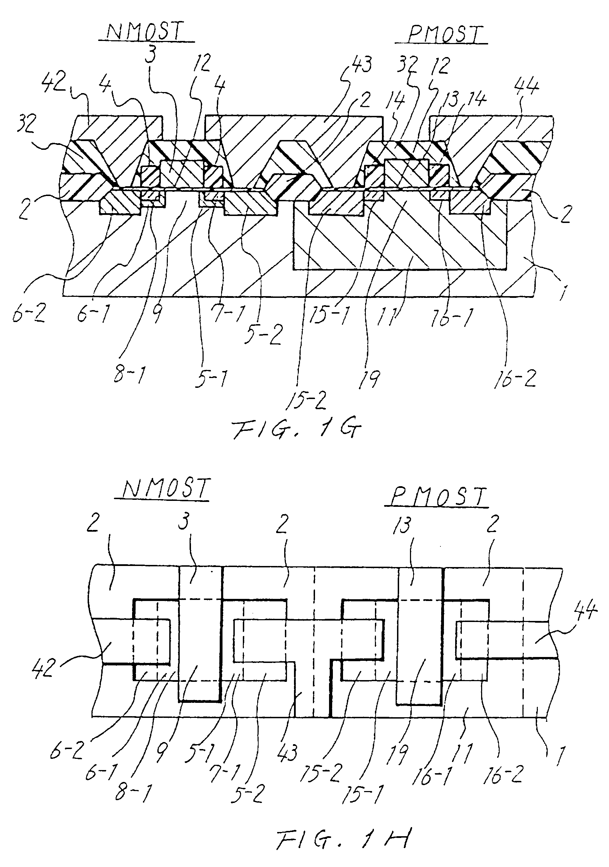

Referring to Figs. 1G and 1H, the first embodiment of the CMOS IC according to the present invention comprises a n-channel MOS transistor (NMOST) formed on the surface of a p-type semiconductor substrate 1 which has a rectangular surface area (active area) surrounded by element-isolating insulating layers 2, and a p-channel MOS transistor (PMOST) formed on the surface area of a n-well 11 provided in the p-type semiconductor substrate 1 and having a rectangular surface area (active area) surrounded by element-isolating insulating zones 2. For simplification of the description, any element other than the above-mentioned is not shown and its explanation will be omitted.

In the active area of the NMOST, there is provided spaced apart a pair of HIC n-type drain/source layers 5-2, 6-2 each at opposite ends, respectively. There is additionally provided at respective inner sides of the pair of HIC drain/source layers a pair of angle-shaped n-type drain/source layers 5-1, 6-1 spaced apart from each other to define a channel region 9 between them. They are located at a small depth and are lower in impurity concentration compared with HSC n-type drain/source layers 5-2, 6-2. There is further provided a gate electrode 3 above the channel 9 through the intermediation of a gate insulating layer 12. A pair of p-type regions 7-1, 8-1 are found each defined by the insulating layer 12, the HSC drain/source layers 5-2, 6-2 and the LIC drain/source layers 5-1, 6-1, respectively. There is further provided sidewall spacers 4 of insulating material each at the opposite sides of the gate electrode, respectively, and above the p-type regions 7-1 and 8-1, respectively.

In the active area of PMOST or the n-well 11, there is provided a pair of HIC p-type drain/source layers 15-2, 16-2 each at opposite ends, respectively. There is additionally provided each at the respective inner sides of the pair of HIC drain/source layers 15-2, 16-2, a pair of p-type drain/source layers 15-1, 16-1 spaced apart from each other to define a channel region 19 between them. They are small in depth and low in impurity concentration compared with HIC n-type drain/source layers 15-2, 16-2. There is further provided a gate electrode 13 above the channel region 19 through the intermediation of a gate insulating layer 12. A pair of sidewall spacers 14 of insulating material are provided at the opposite sides of the gate electrode 13, respectively, and above p-type regions 15-1 and 16-1, respectively.

HIC source region 6-2 of NMOST is connected to a ground line 42. HIC source layer 16-2 of PMOST is connected to a power supply line 44. HIC drain layers 5-2 and 16-2 of both transistors are connected to a common output line 43. The gate electrodes 3 and 13 of both transistors are connected to a common input line. Thus both transistors constitute a CMOS inverter circuit.

Referring to Figs. 1A through 1H, the process of fabricating the CMOS IC detailed as the first embodiment will be described in steps.

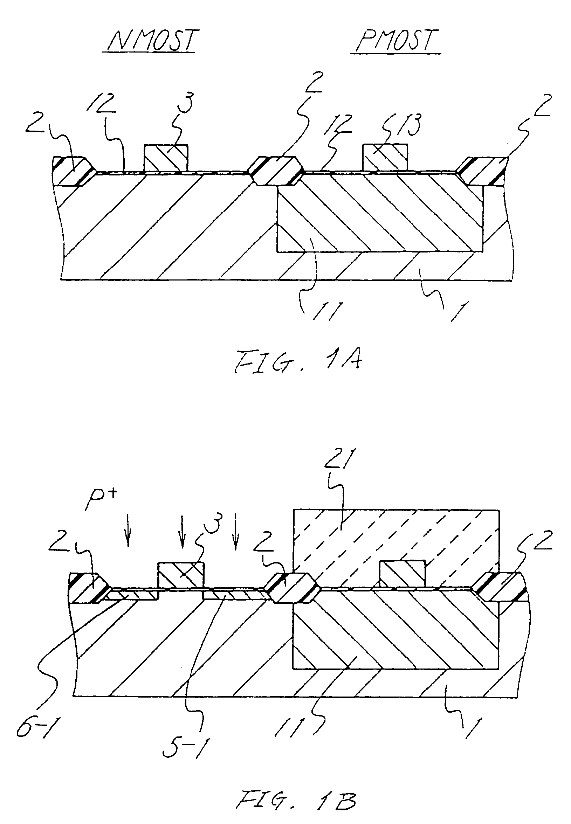

Referring to Fig. 1A, a n-well 1l is formed by a known technique in a p-type silicon substrate 1 containing boron at a concentration of 1 x 10¹⁶ cm⁻³. The n-well 11 contains phosphorus at a concentration of 1 x 10¹⁷ cm⁻³ and has a depth of 4 » cm. On the surface of the silicon substrate 1, element-isolating insulating layers 2 of silicon dioxide at 4,000 Å thick are formed to define active areas. On the surface of each active area, a gate insulating layer 12 of 200 Å thick is formed. At the center of each active area a non-doped polysilicon layer 3 or 13 is formed as a gate electrode of 3000 Å thick and 0.8 » cm in width which corresponds to the channel length. In the next step illustrated in Fig. 1B, after the active area of the part to be formed into PMOST is covered with a photoresist 21, phophorus ions (P⁺) are injected into the part of the active area to be formed into NMOST to form regions 5-1, 6-1 self-aligned with the gate electrode 3 and the element-isolating insulating layers 2 by the utilization of them as masks. The ion injection is carried out at a dose of approximately 1 x 10¹³ cm⁻² and 50 to 60 KeV. The photoresist 21 is removed, and then heat-treatment for the activation of impurity is made at 900°C for one hour. As the result, LIC (impurity concentration: 5 x 10¹⁷ cm⁻³ to 8 x 10¹⁸ cm⁻³) source/drain layers 6-1, 5-1 are formed on the active area self-aligned with the gate electrode. These layers are 0.2 » cm in depth. This ion injection is carried out at relatively high energy (50 to 60 KeV) to cause the peak concentration to be deep. In this case, it is found at 600 Å deep.

In the next step, the photoresist 21 is removed. As shown in Fig. 1C, BF₂ ions are injected into both NMOST and PMOST active areas at a low energy of 10 to 20 KeV at a dose of 10¹³ cm⁻² and heat-treated at 850°C for 1 hour. Thereby in the NMOST part, p-type diffusion regions 7-1, 8-1 of 0.1 » cm thick and 1 x 10¹⁸ cm⁻³ in impurity concentration are formed on the surfaces of the LIC layers 5-1, 6-1, respectively, and simultaneously on the surface of the active area of the n-well 11, a pair of p-type diffusion layers 15-1, 16-1 as LIC PMOST drain/source layers are formed. This ion injection is carried out by the utilization of gate electrodes 3, 13 and element-isolating insulating layers 2 as masks. In the NMOST part, this ion injection is made with the same masks as those for forming the above-mentioned LIC drain/source layers, and hence additional photolithographic processing steps can be omitted. P-type diffusion regions 7-1, 8-1 are formed in self-alignment with the gate electrode 3 while LIC drain/source layers 5-1, 6-1 diffuse and spread so that the p-type diffusion layers 7-1, 8-1 each are enclosed by LIC drain/source layers 5-1, 6-1, respectively. Eventually they are separated by 0.07 » cm in width from the channel region 9 by LIC drain/source regions 5-1, 6-1. Likewise p-type LIC drain/source regions 15-1, 16-1 are formed in self-alignment with gate electrode 13. This step of ion injection is carried out at such a low energy that p-type diffusion layers 7-1, 8-1 is formed at a small depth from the surface.

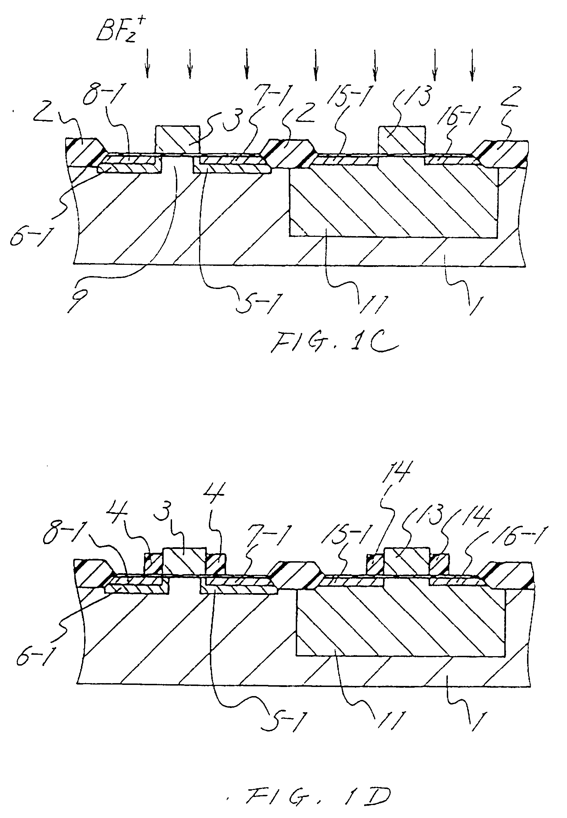

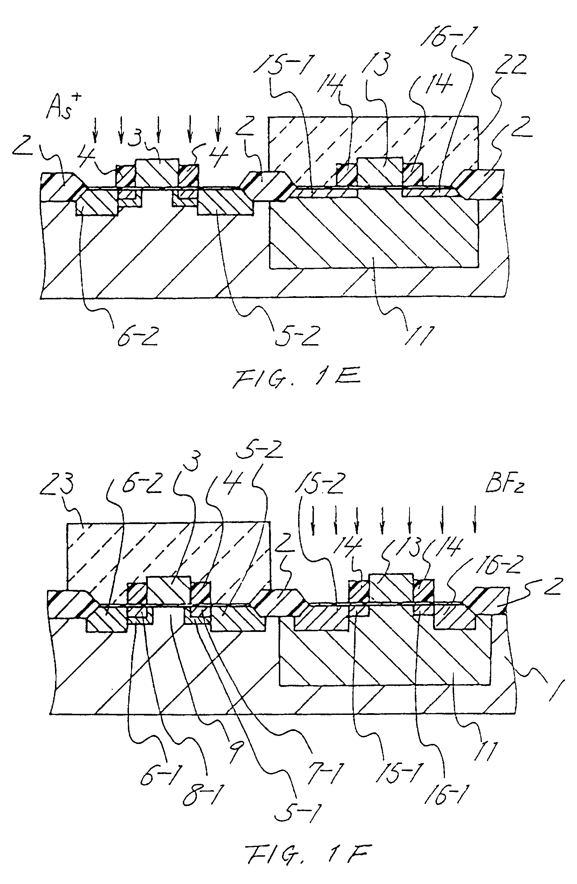

In the following step, in each active area, a pair of sidewall spacers 4 or 14 each are formed on the opposite sides of gate electrode 3 or 13, respectively, as shown in Fig. 1D. This can be accomplished by depositing silicon dioxide film according to the CVD technique as a film of 2,000 to 3,000 Å thick, followed by anisotropic etching of the entire surface. They have each the same width of 2000 to 3000 Å. In the next step, after the PMOST part is covered with a photoresist 22, as shown in Fig. 1E, arsenic ions (As⁺) are injected into the NMOST part at 50 KeV. In this case, not only gate electrode 3 but also sidewall spacers 4 serve as masks. At ends of the active area, respectively, each of HIC n-type drain/source regions 5-2, 6-2 are formed in self-alignment with sidewall spacer 4 and element-isolating insulating layer 2. After heat-treatment, HIC drain/source regions 5-2, 6-2 each having a depth 0.3 » cm, and an impurity concentration of 1 x 10²⁰ cm⁻³ result.

Then, as shown in Fig. 1F, the NMOST part is covered with a photoresist 23, BF₂⁺ ions are injected at 50 KeV. Likewise gate electrode 13, sidewall spacers 14 and element-isolating insulating layers 2 serve as masks. At ends of the active area of the n-well 11, respectively, each of HIC p-type drain/source layers 15-2, 16-2 is formed in self-alignment with sidewall spacer 4 and element-isolating insulating layer 2. Thus HIC p-type drain/source layers 15-2, 16-2 each having a impurity concentration of about 1 x 10²⁰ cm⁻³ and a depth of 0.4 u cm are obtained.

In the final step shown in Fig. 1G, the entire surface is covered with interlayer insulating film 32 in which then through-holes, for example, to the surfaces of HIC drain-source layers 5-2, 6-2, 15-2 and 16-2 are opened. Through the intermediation of contacts extending through the through-holes, the aluminium wiring comprising 42, 43 and 44 can be constructed.

In the NMOST of this embodiment, the sidewall spacer 4 is separated from n-type drain layers 5-1, 5-2 by p-type diffusion region 7-1, which effects to reduce injection of hot carriers into the sidewall spacer and thereby to prevent initial lowering of transconductance as observed in the prior art, contributing to improvement in the reliability of the transistor. The application of the present invention to the NMOST of LDD structure in a CMOS IC as in this embodiment permits also the PMOST to be formed in LDD structure only by the addition of the processing step of FIG. 1C, that is, without needing addition of photolithographic processing steps therefor.

Referring to Fig. 2C, a CMOS IC of the second embodiment according to the present invention has a structure incorporating a pair of second p-type diffusion layers 7-2, 8-2 in addition to the structure of the first embodiment. The pair of second p-type diffusion layers 7-2, 8-2 are formed in angle-shape to define a channel region 9 between them and to surround LIC n-type drain/source layers 5-1, 6-1, respectively, in conjunction with HIC n-type layers 5-2, 6-2. They are 0.3 u cm thick and approximately 1 x 10¹⁷ cm⁻³ in impurity concentration.

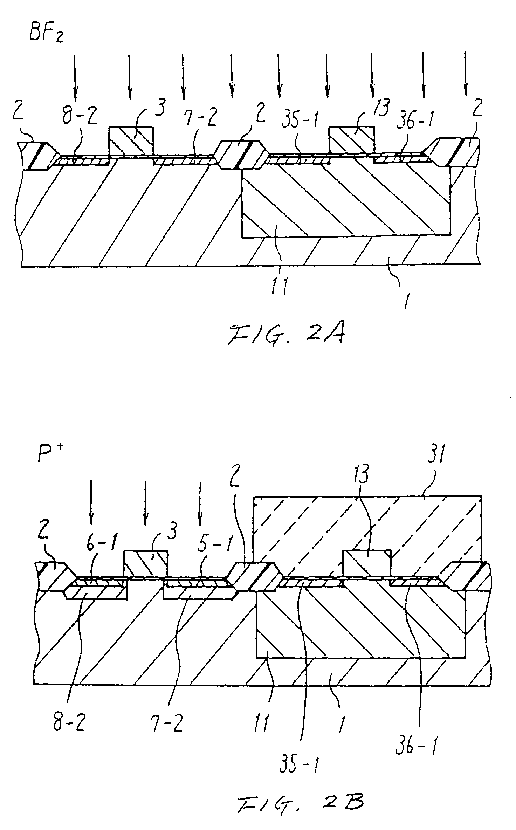

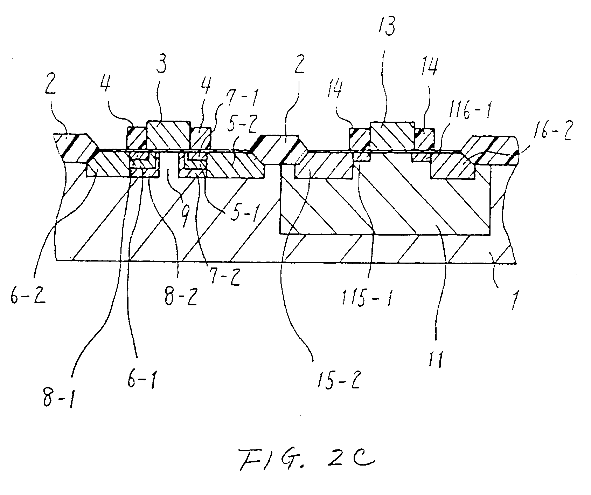

Referring to Figs. 2A through 2C, the process of fabricating the second embodiment of the present invention is described. After the structure of Fig. 1A is made, BF₂⁺ ions are injected into the entire surface at a relatively high energy of about 1000 KeV energy, as shown in Fig. 2A to form a pair of p-type diffusion layers 7-2, 8-2 in the active area of the NMOST part and another pair of p-type diffusion layers 35-1, 36-1 in the active area of the PMOST (n-well) part, respectively. The subsequent steps proceed as in the first embodiment. As illustrated in Fig. 2B, the PMOST part is covered with a photoresist 31, and then injection of phosphorus ions is carried out into the NMOST part so that n-type LIC drain/source layers 5-1, 6-1 are formed to be enclosed by the p-type diffusion layers 7-2, 8-2. Subsequently in the same way as the first embodiment, BF₂⁺ ions are injected into the entire surface to form sidewall spacers 4, 14. Then high level drain/source layers 5-2, 6-2, 15-2, 16-2 are formed, and thus the structure illustrated in Fig. 2C is obtained. Moreover the p-type LIC drain/source layers 115-1, 116-1 in the PMOST part are higher in impurity concentration in virtue of the injection of BF₂⁺s ions as illustrated in Fig. 2A than p-type LIC drain/source layers 15-1, 16-1 in Fig. 1G.

In the second embodiment, each of n-type LIC drain/source layers 5-1, 6-1 is enclosed by p-type diffusion layers 7-2, 8-2, respectively, which are higher in impurity concentration than p-type semiconductor substrate 1, leading to improvement in punch-through voltage between the source and drain. The punch-through voltage is noted as an increased value of at least 12 V in compared with the structure of Fig. 1G noted to be at least 8 V, and this can contribute to shorter width between the source and drain, and in turn to a finer transistor structure.

## Claims

1. A MOS transistor comprising:
a first source layer (6-2) and a first drain layer (5-2) formed with a space therebetween on the surface in a one-conductivity-type part of a semiconductor substrate (1), said first source/drain layers having a conductivity type opposite to said one-conductivity-type;
a pair of second source/drain layers (5-1,6-1) formed on the surface in said one-conductivity-type part of said semiconductor substrate to be opposed to each other with a region (9) remaining at respective inner sides of said first source/drain layers, said second source/drain layers being smaller in depth and lower in impurity concentration than said first source/drain layers;
a gate electrode (3) formed above said remaining region in said one-conductivity-type part of said semiconductor substrate through the intermediation of a gate-insulating layer (12); and
a pair of sidewall spacers (4) of insulating material each formed above said pair of one-conductivity-type regions, respectively, and flanked with the opposite sides of said gate electrode, respectively; characterised in that a pair of regions (7-1,8-1) of said one conductivity-type is formed to be on a partial surface of said second source/drain layers, respectively, and is separated from said remaining region.

2. A CMOS integrated circuit comprising:
a first n-type source layer (6-2) and a first n-type drain layer (6-1) formed on the surface in a p-type part (1) of a semiconductor substrate to (1,11) be opposed to each other with a space therebetween;
a pair of second n-type source/drain layers (5-1,6-1) formed on the surface in said p-type part of said semiconductor substrate to be opposed to each other with a region (9) remaining, each thereof at respective inner side of said first n-type source/drain layers, and being smaller in depth and lower in impurity concentration than said first n-type source/drain layers;
a first gate electrode (3) formed above said remaining region in said p-type part of said semiconductor substrate through the intermediation of a gate-insulating layer (12);
a pair of first sidewall spacers (4) of insulating material each formed above said pair of p-type regions, respectively, and flanked with the opposite sides of said first gate electrode, respectively,
a first p-type source layer (15-2) and a first p-type drain layer (16-2) formed on the surface in a n-type part (11) of said semiconductor substrate to be opposed to each other with a space therebetween;
a pair of second p-type source/drain layers (15-1,16-1) formed on the surface in said n-type part of said semiconductor substrate to be opposed to each other with a region (19) left, each thereof at respective inner sides of said first p-type source/drain layers and being smaller in depth and lower in impurity concentration than said first p-type source/drain layers;
a second gate electrode (13) formed above said left region in said n-type part of said semiconductor substrate through the intermediate of a gate-insulating layer (12); and
a pair of second sidewall spacers (14) of insulating material each formed above said pair of second p-type source/drain regions, respectively, and flanked with the opposite sides of said second gate electrode, respectively characterised in that
a pair of p-type regions (7-1,8-1) each is formed to be on said pair of second n-type source/drain layers, respectively, and is separated thereby from said remaining region.

3. A process of fabricating a n-channel MOS transistor according to claim 1 comprising in steps:
forming a gate-insulating layer (12) on the surface in a p-type part of a semiconductor substrate (1);
forming a gate electrode (3) on said gate-insulating layer;
introducing a first n-type impurity in self-alignment with said gate electrode into the surface in said p-type part of said semiconductor substrate;
introducing a p-type impurity in self-alignment with said gate electrode into the same surface as in said first n-type impurity introduction;
forming a pair of sidewall spacers (4) each at sides of said gate electrode, respectively; and
additionally introducing a second n-type impurity in self-alignment with said pair of sidewall spacers into partially the same surface as said first n-type impurity introduction.

## Patentansprüche

1. MOS-Transistor mit:
einer ersten Sourceschicht (6-2) und einer ersten Drainschicht (5-2), die mit einem Raum zwischen sich auf der Oberfläche eines Teils eines Leitfähigkeitstyps eines Halbleitersubstrats (1) ausgebildet sind, wobei die erste Source-/Drainschicht einen Leitfähigkeitstyp aufweist, der entgegengesetzt zu dem einen Leitfähigkeitstyp ist,
einem Paar zweiter Source-/Drainschichten (5-1, 6-1), die auf der Oberfläche in dem Teil eines Leitfähigkeitstyps des Halbleitersubstrats entgegengesetzt zueinander ausgebildet sind, wobei ein Bereich (9) an den entsprechenden Innenseiten der ersten Source-/Drainschichten verbleibt, wobei die zweiten Source-/Drainschichten eine geringere Tiefe und eine geringere Störstoffkonzentration als die ersten Source-/Drainschichten aufweisen,
eine Gateelektrode (3), die auf dem verbleibenden Bereich in dem Teil eines Leitfähigkeitstyps des Halbleitersubstrats unter Zwischenfügung einer Gateisolierschicht (12) ausgebildet ist, und
einem Paar Seitenwand-Abstandshaltern (4) aus Isoliermaterial, die jeweils auf dem Paar der Bereiches eines Leitfähigkeitstyps ausgebildet sind und durch die gegenüberliegenden Seiten der Gateelektrode flankiert werden, dadurch **gekennzeichnet**, daß das Paar Bereiche (7-1; 8-1) des einen Leitfähigkeitstyps so gebildet ist, daß es auf einer Teilfläche der zweiten Source-/Drainschichten ausgebildet ist und von dem verbleibenden Bereich getrennt ist.

2. Integrierte CMOS-Schaltung mit:
einer ersten n-Sourceschicht (6-2) und einer ersten n-Drainschicht (6-1), die auf der Oberfläche in einem p-Teil eines Halbleitersubstrats (I, 1) ausgebildet sind, um einander mit einem Raum dazwischen gegenüberzuliegen,
einem Paar n-Source-/Drainschichten (5-1, 6-1), die auf der Oberfläche in dem p-Teil des Halbleitersubstrats ausgebildet sind, um einander mit einem verbleibenden Bereich (9) gegenüberzuliegen, wobei jede an der entsprechenden Innenseite der ersten n-Source-/Drainschichten liegt und eine geringere Tiefe und eine geringere Fremdstoffkonzentration als die ersten n-Source-/Drainschichten aufweist,
einer ersten Gateelektrode (3), die auf dem verbleibenden Bereich in dem p-Teil des Halbleitersubstrats unter Zwischenfügung eines Gateisolierfilms (12) ausgebildet ist,
einem Paar erster Seitenwandabstandshalter (4) aus Isoliermaterial, die jeweils über dem Paar der p-Bereiche ausgebildet sind und durch die gegenüberliegenden Seiten der ersten Gateelektrode flankiert sind,
einer ersten p-Sourceschicht (15-2) und einer ersten p-Drainschicht (16-2), die auf der Oberfläche in einen n-Teil (11) des Halbleitersubstrats ausgebildet sind, um einander mit einem Raum dazwischen gegenüberzuliegen,
einem Paar zweiter p-Source-/Drainschichten (15-1, 16-1), die auf der Oberfläche in dem n-Teil des Halbleitersubstrats ausgebildet sind, um einander gegenüberzuliegen, mit einem verbleibenden Bereich (19), jeder an entsprechenden Innenseiten der ersten p-Source-/Drainschichten und mit geringerer Tiefe und mit geringerer Fremdstoffkonzentration als die ersten p-Source-/Drainschichten,
einer zweiten Gateelektrode (13), die über dem verbleibenden Bereich in dem n-Teil des Halbleitersubstrates unter Zwischenfügung eines Gateisolierfilms ausgebildet ist, und einem zweiten Paar Seitenwand-Abstandshaltern (14) aus Isoliermaterial, die jeweils oberhalb des Paares der zweiten p-Source-/Drainbereiche ausgebildet sind und mit den gegenüberliegenden Seiten der zweiten Gateelektrode flankiert sind, dadurch **gekennzeichnet**, daß ein Paar p-Bereiche (7-1, 8-1) jeweils ausgebildet ist, um auf dem Paar der zweiten n-Source-/Drainschichten zu liegen und somit von den verbleibenden Bereich getrennt zu sein.

3. Verfahren zur Herstellung eines n-Kanal-MOS-Transistors nach Anspruch 1 mit den Schritten:
Ausbilden einer Gateisolierschicht (12) auf der Oberfläche in einem p-Teil eines Halbleitersubstrats (1),
Ausbilden einer Gateelektrode (3) auf der Gateisolierschicht,
Einbringen eines n-Störstoffs in Selbstausrichtung mit der Gateelektrode in die Oberfläche des p-Teils des Halbleitersubstrats,
Einbringen eines p-Störstoffs in Selbstausrichtung mit der Gateelektrode in diesselbe Oberfläche wie bei der Einbringung des ersten n-Störstoffs,
Ausbilden eines Paares Seitenwand-Abstandshalter (4) jeweils an den Seiten der Gateelektrode, und
zusätzliches Einbringen eines zweiten n-Störstoffs in Selbstausrichtung mit dem Paar der Seitenwand-Abstandshalter in teilweise diesselbe Oberfläche wie bei der Einbringung des ersten n-Störstoffs.

## Revendications

1. Transistor MOS comprenant :
- une première couche de source (6-2) et une première couche de drain (5-2) formées avec un espace entre elles, sur la surface dans une partie d'un type de conductivité d'un substrat semi-conducteur (1), lesdites couches de source et de drain ayant un type de conductivité opposé audit un type de conductivité;
- une paire de secondes couches de source et de drain (5-1, 6-1) formées sur la surface dans ladite partie d'un type de conductivité dudit substrat semi-conducteur, de manière à être en face l'une de l'autre avec une région (9) restant, du côté intérieur respectivement desdites premières couches de source et de drain, lesdites secondes couches de source et de drain ayant une profondeur plus petite et une concentration plus faible en impuretés que lesdites premières couches de source et de drain;
- une électrode de grille (3) formée au-dessus de ladite région restante dans ladite partie d'un type de conductivité dudit substrat semi-conducteur, séparée par l'intermédiaire d'une couche d'isolation de grille (12); et
- une paire de parois latérales d'espacement (4) en matériau isolant, formée chacune au-dessus de ladite paire de régions d'un type de conductivité, respectivement, et adjacente aux côtés opposés de ladite électrode de grille, respectivement,
caractérisé en ce qu'une paire de régions (7-1, 8-1) dudit un type de conductivité est formée de manière à être sur une surface partielle desdites secondes couches de source et de drain, respectivement, et est séparée de ladite région restante.

2. Circuit intégré CMOS comprenant :
- une première couche de source (6-2) du type n et une première couche de drain (5-2) du type n, formées sur la surface dans une partie (1) du type p d'un substrat semiconducteur (I, 1), de manière à être en face l'une de l'autre avec un espace entre elles;
- une paire de secondes couches de source et de drain (5-1, 6-1) du type n formées sur la surface dans ladite partie du type p dudit substrat semi-conducteur, de manière à être en face l'une de l'autre avec une région (9) restant, chacune d'elles étant du côté intérieur respectivement desdites premières couches de source et de drain du type n, et ayant une profondeur plus petite et une concentration plus faible en impureté que lesdites premières couches de source et de drain du type n;
- une première électrode de grille (3) formée au-dessus de ladite région restante dans ladite partie de type p dudit substrat semi-conducteur, séparée par l'intermédiaire d'une couche d'isolation de grille (12);
- une paire de premières parois latérales d'espacement (4) en matériau isolant, formée chacune au-dessus de ladite paire de régions du type p, respectivement, et adjacente aux côtés opposés de ladite première électrode de grille, respectivement,
- une première couche de source (15-2) du type p et une première couche de drain (16-2) du type p, formées sur la surface dans une partie (11) du type n dudit substrat semiconducteur, de manière à être en face l'une de l'autre avec un espace entre elles;
- une paire de secondes couches de source et de drain (15-1, 16-1) du type p formées sur la surface dans ladite partie du type n dudit substrat semi-conducteur, de manière à être en face l'une de l'autre en laissant une région (19), chacune d'elles étant du côté intérieur respectivement desdites premières couches de source et de drain du type p, et ayant une profondeur plus petite et une concentration plus faible en impureté que lesdites premières couches de source et de drain du type p;
- une seconde électrode de grille (13) formée au-dessus de ladite région laissée dans ladite partie du type n dudit substrat semi-conducteur, séparée par l'intermédiaire d'une couche d'isolation de grille (12); et
- une paire de secondes parois latérales d'espacement (14) en matériau isolant, formée chacune au-dessus de ladite paire de secondes couches de source et de drain du type p, respectivement, et adjacente aux côtés opposés de ladite seconde électrode de grille, respectivement,
caractérisé en ce que une paire de régions (7-1, 8-1) du type p est formée de manière à être sur ladite paire de secondes couches de source et de drain du type n, respectivement, et est séparée de ladite région restante par celle-ci.

3. Procédé de fabrication d'un transistor MOS à canal n suivant la revendication 1, comprenant les étapes suivantes :
- la formation d'une couche d'isolation de grille (12) sur la surface dans une partie du type p d'un substrat semiconducteur (1);
- la formation d'une électrode de grille (3) sur ladite couche d'isolation de grille;
- l'introduction d'une première impureté du type n en auto-alignement avec ladite électrode de grille dans la surface dans ladite partie du type p dudit substrat semi-conducteur;
- l'introduction d'une impureté du type p alignée avec ladite électrode de grille dans la même surface que celle d'introduction de ladite première impureté du type n;
- la formation d'une paire de parois latérales d'espacement (4) sur les côtés de ladite électrode de grille, respectivement; et
- l'introduction additionnelle d'une seconde impureté du type n en auto-alignement avec ladite paire de parois latérales d'espacement dans une partie de la même surface que celle d'introduction de ladite première impureté du type n.
